# EUROPEAN PATENT APPLICATION

(11) **EP 3 929 150 A1**
(43) Date of publication of application: **29.12.2021**
(21) Application number: 20208051.1
(22) Date of filing: 17.11.2020
(51) Int. Cl.: B82Y 10/00, H01L 29/06, H01L 29/423, H01L 29/51, H01L 29/66, H01L 29/775

(54) **PLASMA NITRIDATION FOR GATE OXIDE SCALING OF GE AND SIGE TRANSISTORS**

(30) Priority: 26.06.2020 US 202016913848
(71) Applicant: INTEL Corporation, Santa Clara, CA 95054 (US)
(72) Inventor: CHOUKSEY, Siddharth, Portland, OR Oregon 97229 (US); AGRAWAL, Ashish, Hillsboro, OR Oregon 97124 (US); SUNG, Seung, Portland, OR Oregon 97229 (US); KAVALIEROS, Jack, Portland, OR Oregon 97229 (US); METZ, Mathew, Portland, OR Oregon 97229 (US); RACHMADY, Willy, Beaverton, OR Oregon 97007 (US); TORRES, Jessica, Portland, OR Oregon 97229 (US); MITAN, Martin, Beaverton, OR Oregon 97006 (US)
(74) Representative: Goddar, Heinz J.

(57) **Abstract**

Embodiments disclosed herein include nanowire or nanoribbon semiconductor devices and methods of forming such devices. In an embodiment, a semiconductor device comprises a stack of semiconductor nanowire or nanoribbon channels (410) with a first end and second end. Individual ones of the semiconductor channels comprise a nitrided surface (415), formed by a plasma treatment of the semiconductor channels. The semiconductor device further comprises a source region (405) at the first end of the stack, a drain region (405) at the second end of the stack, a gate dielectric (417) surrounding the nitrided semiconductor channels, and a gate electrode (419) surrounding the gate dielectric.

## Description

### TECHNICAL FIELD

Embodiments of the present disclosure relate to semiconductor devices, and more particularly to nanoribbon transistors with channels that are nitrided with a low temperature plasma nitridation process.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

In the manufacture of integrated circuit devices, gate all around (GAA) transistors, such as nanoribbon and nanowire transistors, have become more prevalent as a way to provide further scaling down of dimensions. Particularly, GAA transistors allow for improved short channel effects and allow for additional scaling of transistor devices. Scaling GAA transistors has not been without consequence, however. As the dimensions of these fundamental building blocks of microelectronic circuitry are reduced and as the sheer number of fundamental building blocks fabricated in a given region is increased, the constraints on the semiconductor processes used to fabricate these building blocks have become overwhelming.

### BRIEF DESCRIPTION OF THE DRAWINGS

Figure 1 is a cross-sectional illustration of a nanoribbon channel that has been nitrided with a thermal process.
Figure 2A is a cross-sectional illustration of a nanoribbon channel that has been nitrided with a low temperature plasma process, in accordance with an embodiment.
Figure 2B is a cross-sectional illustration of the nanoribbon channel in Figure 2A along line B-B', in accordance with an embodiment.
Figure 2C is a graph of nitrogen count along a line from point A to point D in Figure 2B, in accordance with an embodiment.
Figure 3 is a flow chart depicting a process for forming a transistor device with a nitrided nanoribbon channel using a low temperature plasma nitridation process, in accordance with an embodiment.
Figure 4A is a cross-sectional illustration of a transistor device with the sacrificial gate structure removed, in accordance with an embodiment.
Figure 4B is a cross-sectional illustration of the transistor device after the nanoribbon channels are nitrided with a low temperature plasma process, in accordance with an embodiment.
Figure 4C is a cross-sectional illustration of the transistor device after a gate dielectric is disposed over the nanoribbon channels, in accordance with an embodiment.
Figure 4D is a cross-sectional illustration of the transistor device after a gate electrode is disposed around the gate dielectric, in accordance with an embodiment.
Figure 5 illustrates a computing device in accordance with one implementation of an embodiment of the disclosure.
Figure 6 is an interposer implementing one or more embodiments of the disclosure.

### EMBODIMENTS OF THE PRESENT DISCLOSURE

Described herein are nanoribbon transistors with channels that are nitrided with a low temperature plasma nitridation process, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

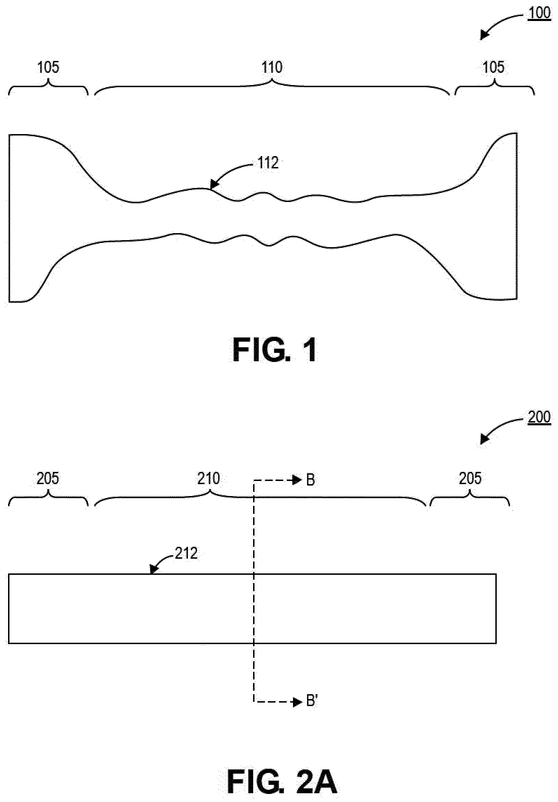

As noted above, the continued scaling of gate all around (GAA) transistor devices is not without issue. In thin body structures, such as nanoribbon or nanowire devices, the nitridation of the channel may damage the channels. This damage is particularly of issue in the case of germanium or silicon-germanium channels. The damage to the channels may result in a deformation of the channel. Such a deformed channel 110 is shown in the device 100 of Figure 1. As shown, between the source/drain (S/D) regions 105, the nanoribbon channel is etched back and provides a rough surface 112. It has been shown that the resulting surface roughness of the surface 112 is significantly higher than 1.0nm root mean square (RMS). The deformation of the channels 110 is the result of the high temperature (e.g., approximately 650°C or greater) and the nitriding gas (e.g., NH₃). This is because, at high temperatures, the nitriding gas may actually etch the channel 110 in addition to nitriding the surface.

Accordingly, embodiments disclosed herein include a low temperature nitriding process that prevents deformation of the semiconductor channel. Particularly, embodiments include a low temperature plasma process. For example, a plasma formed from N₂ source gas at temperatures at approximately 350°C or below may be used for the nitridation process. The use of a plasma disassociates the N₂ gas to provide reactive N⁺ ions in order to allow for the nitridation of the surface at the lower temperatures. Without the etching of the semiconductor channel, the semiconductor channel may exhibit an extremely low surface roughness. For example, a surface roughness of the semiconductor channel may be approximately 1.0nm RMS or lower, or approximately 0.5nm RMS or lower. Such a nitriding process is particularly beneficial to semiconductor channels that comprise germanium or silicon and germanium.

Figure 2A is a cross-sectional illustration of a nitrided semiconductor device 200. In Figure 2A, a channel region 210 is between S/D regions 205. In an embodiment, the channel region 210 may comprise a semiconductor material. In a particular embodiment, the channel region 210 comprise germanium or silicon and germanium. However, it is to be appreciated that embodiments are not limited to such semiconductor materials. In an embodiment, the channel region 210 may be a nanoribbon channel or a nanowire channel.

In an embodiment, the channel region 210 has been nitrided using a low temperature nitridation process. Suitable low temperature processes are described in greater detail below. Generally, embodiments include a nitriding process that utilizes a plasma with a nitrogen containing source gas at a temperature that is approximately 350°C or lower. The nitriding process provides a relatively high concentration of nitrogen (not shown) at a surface 212 of the channel region 210. In an embodiment, the high concentration of the nitrogen may be substantially uniform around a perimeter of the channel region. In some embodiments, the high concentration of nitrogen may not be a visible layer. However, a peak of nitrogen atoms may be demonstrated by use of secondary-ion mass spectrometry (SIMS) analysis, for example. As shown, the channel region 210 in Figure 2A does not exhibit deformation. In a particular embodiment, a surface roughness of the surface 212 may be approximately 1.0nm RMS or lower, or approximately 0.5nm RMS or lower. As used herein, reference to "approximately" may refer to a range of values within plus or minus 10% of the stated value.

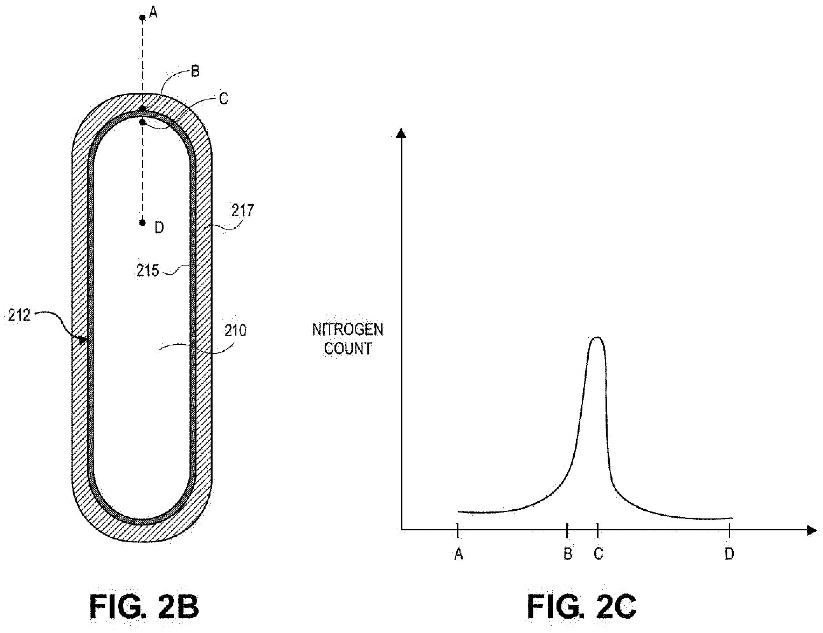

Referring now to Figure 2B, a cross-sectional illustration of channel region 210 along line B-B' in Figure 2A is shown, in accordance with an embodiment. As shown, a thin layer 215 of high nitrogen concentration is provided around an entire perimeter of the channel region 210. In the illustrated embodiment, a high-k dielectric layer 217 is also shown surrounding an entire perimeter of the channel region 210. The layer 215 of high nitrogen concentration may separate the un-nitrided channel region 210 from the high-k dielectric layer 217.

The layer 215 of high nitrogen concentration is shown in Figure 2B for clarity. However, as noted above, the layer 215 may not be clearly distinguishable using various analytical techniques (e.g., transmission electron spectroscopy (TEM)). Instead, the presence of the layer 215 may be determined using an analytical technique that allows for chemical composition to be determined. One such analytical technique that may be used is SIMS analysis.

Referring now to Figure 2C a graph of nitrogen concentration (e.g., nitrogen count) along a line from point A to point D in Figure 2B is shown, in accordance with an embodiment. As shown, at the interior surface of the high-k dielectric layer 217 (i.e., at point B) a peak of nitrogen is provided. The peak is relatively sharp and ends at point C at a small distance into the semiconductor channel 210. The width of the peak (e.g., approximately 1nm or less) represents the presence of the layer 215 around the semiconductor channel 210.

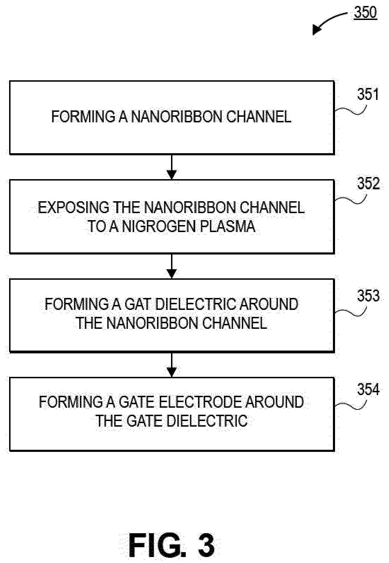

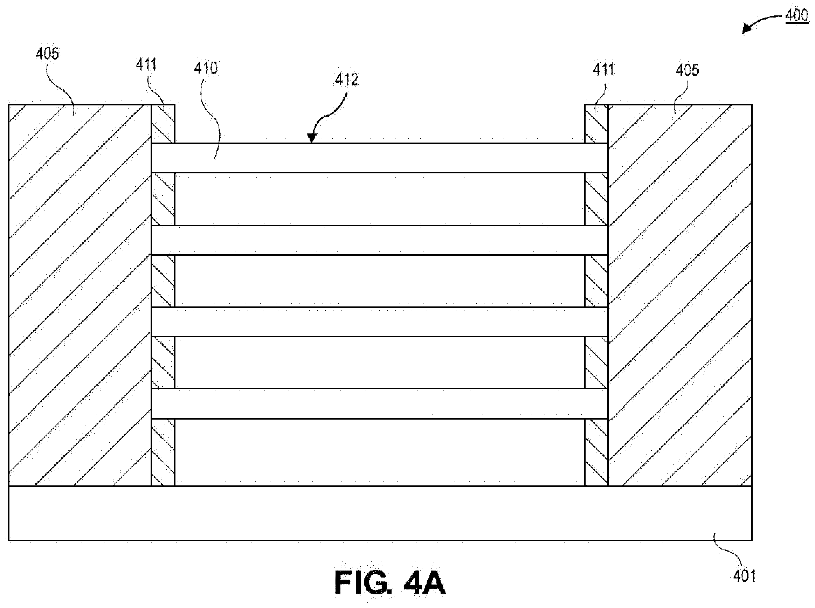

Referring now to Figure 3, a process flow diagram depicting a process 350 for forming a transistor device is shown, in accordance with an embodiment. The processing operations 351-354 are described with respect to Figures 4A-4D. In Figures 4A-4D, the semiconductor channel is described as being a nanoribbon channel. However, it is to be appreciated that substantially similar processes may be used to form a transistor device with a nanowire channel or any other GAA transistor structure.

Process 350 may begin with operation 351 which comprises forming a nanoribbon channel. The result of operation 351 is shown in Figure 4A. As shown, a transistor device 400 comprises a plurality of nanoribbon channels 410 between S/D regions 405. The nanoribbon channels 410 may pass through a pair of spacers 411 to contact the S/D regions 405. In an embodiment, the transistor device 400 may be disposed over a substrate 401. The substrate 401 may be an isolation layer over an underlying semiconductor substrate (not shown). In an embodiment, the underlying semiconductor substrate represents a general workpiece object used to manufacture integrated circuits. The semiconductor substrate often includes a wafer or other piece of silicon or another semiconductor material. Suitable semiconductor substrates include, but are not limited to, single crystal silicon, polycrystalline silicon and silicon on insulator (SOI), as well as similar substrates formed of other semiconductor materials, such as substrates including germanium, carbon, or group III-V materials.

In an embodiment, the resulting structure of transistor device 400 may be formed using any suitable processing operations for the formation of nanoribbon (or nanowire) channels. For example, a stack comprising alternating layers of the nanoribbon channels 410 and a sacrificial material may be patterned into a fin shape. A sacrificial gate structure may be formed over the stack between the spacers 411. After formation of the S/D regions 405, the sacrificial gate structure and the sacrificial layers between the nanoribbon channels 410 maybe removed with suitable etching processes. For example, when the nanoribbon channels 410 are silicon-germanium channels, the sacrificial layers may be silicon layers. In the illustrated embodiment, four nanoribbon channels 410 are provided in a vertical stack over the substrate 401. However, it is to be appreciated that any number of nanoribbon channels 410 (e.g., one or more nanoribbon channels 410) may be provided in the transistor device 400.

In an embodiment, the nanoribbon channels 410 may comprise a semiconductor material. In a particular embodiment, the nanoribbon channels 410 may comprise germanium. In an additional embodiment, the nanoribbon channels 410 may comprise silicon and germanium. In an embodiment, the S/D regions 405 may be epitaxially grown semiconductor material. The S/D regions 405 may be in-situ doped during the epitaxial growth.

Referring again to process 350, the process 350 may continue with operation 352 which comprises exposing the nanoribbon channel to a nitrogen plasma. In an embodiment, the nitrogen plasma is provided using a nitrogen containing source gas. For example, the nitrogen containing source gas may comprise N₂, though other nitrogen containing source gases may also be used. In an embodiment, the plasma process is implemented at a low temperature. Particularly, embodiments may include a temperature that is approximately 350°C or lower, or approximately 300°C or lower.

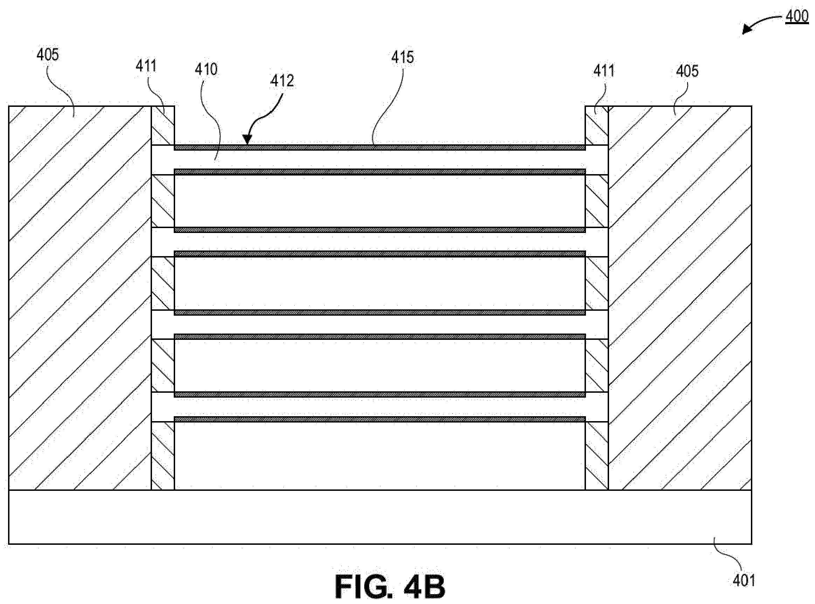

In an embodiment, the resulting structure after operation 352 is shown in Figure 4B. As shown, a layer 415 of high nitrogen concentration is provided around an entire perimeter of the nanoribbon channels 410 between the spacers 411. The portion of the nanoribbon channels 410 that pass through the spacers 411 may be substantially free of nitrogen due to the plasma being blocked by the spacers 411. The visible indication of the layer 415 in Figure 4B is for illustrative purposes. As described above, the layer 415 may not be visible using some inspection techniques, such as TEM. However, the presence of the layer 415 may be determined using compositional analysis techniques, such as SIMS.

Due to the low temperature plasma process, the surface 412 of the nanoribbon channel 410 may have a low surface roughness. This is because the low temperature and the disassociated nitrogen do not actively etch the nanoribbon channel 410, as is the case with a high temperature NH₃ nitridation process, such as the one described above. In a particular embodiment, the surface roughness may be approximately 1.0nm RMS or less, or approximately 0.5nm RMS or less.

Referring again to process 350 in Figure 3, process 350 may continue with operation 353 which includes forming a gate dielectric 417 around the nanoribbon channel 410. The gate dielectric 417 deposition process may be any suitable process for depositing a high-k dielectric material. For example, the gate dielectric 417 may be deposited with an atomic layer deposition (ALD) process or a chemical vapor deposition (CVD) process.

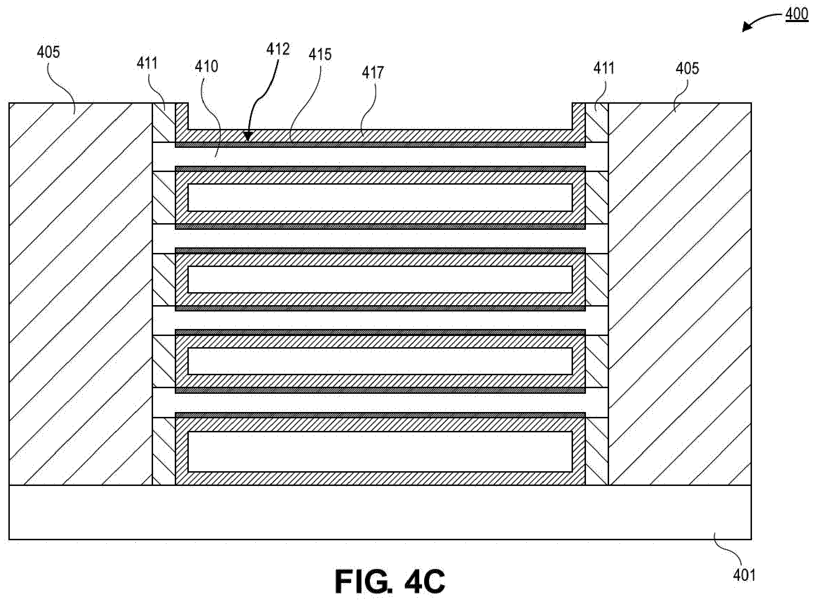

Referring now to Figure 4C, a cross-sectional illustration of the transistor device 400 after the processing operation 353 is shown, in accordance with an embodiment. As shown, the gate dielectric 417 may be conformally deposited over surfaces between the spacers 411. That is, the gate dielectric 417 may line an entire perimeter of the nanoribbon channels 410 as well as the interior sidewalls of the spacers 411. As shown, the layer 415 of high nitrogen concentration may separate the gate dielectric 417 from the bulk of the nanoribbon channels 410 that are substantially free of nitrogen.

In an embodiment, the gate dielectric 417 may be, for example, any suitable oxide such as silicon dioxide or high-k gate dielectric materials. Examples of high-k gate dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

Referring again to process 350 in Figure 3, process 350 may continue with operation 354 which includes forming a gate electrode 419 around the gate dielectric 417. The gate electrode 419 may be formed with any suitable deposition process or processes. For example, an ALD process and/or a CVD process may be used to form the gate electrode 419.

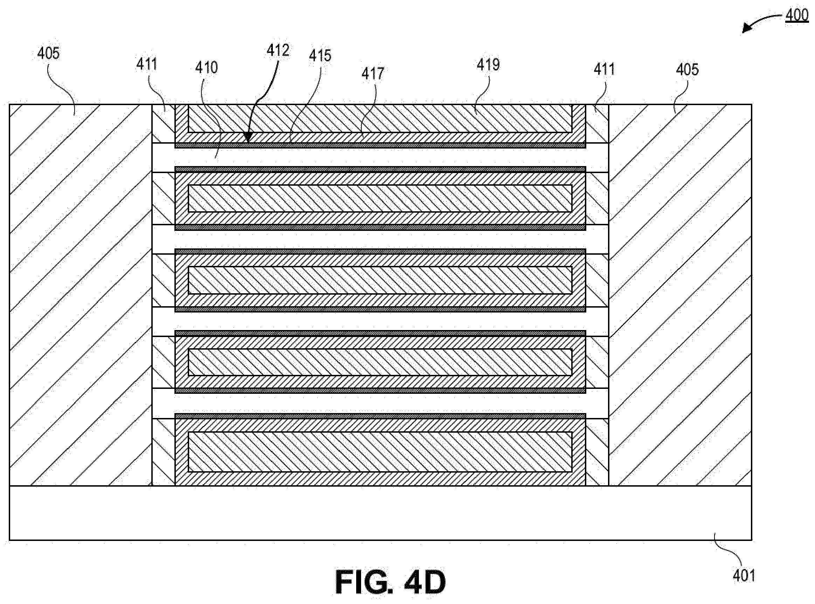

Referring now to Figure 4D, a cross-sectional illustration of the transistor device 400 after operation 354 is implemented is shown, in accordance with an embodiment. As shown, the gate electrode 419 entirely surrounds the nanoribbon channels 410 in order to provide a GAA structure. In an embodiment, the gate electrode 419 may comprise a workfunction metal and a gate fill metal. For example, the workfunction metal may be deposited with a conformal deposition process, and gate fill metal may be deposited with a non-conformal deposition process.

When the workfunction metal will serve as an N-type workfunction metal, the workfunction metal preferably has a workfunction that is between about 3.9 eV and about 4.2 eV. N-type materials that may be used to form the workfunction metal include, but are not limited to, hafnium, zirconium, titanium, tantalum, aluminum, and metal carbides that include these elements, i.e., titanium carbide, zirconium carbide, tantalum carbide, hafnium carbide and aluminum carbide. When the workfunction metal will serve as a P-type workfunction metal, the workfunction metal preferable has a workfunction that is between about 4.9 eV and about 5.2 eV. P-type materials that may be used to form the workfunction metal include, but are not limited to, ruthenium, palladium, platinum, cobalt, nickel, and conductive metal oxides, e.g., ruthenium oxide. The gate fill metal may comprise a wide range of materials, such as polysilicon, silicon nitride, silicon carbide, or various suitable metals or metal alloys, such as aluminum, tungsten, titanium, tantalum, copper, titanium nitride, or tantalum nitride, for example.

The process described above is particularly beneficial for use in thin body semiconductor devices, such as nanoribbon and nanowire devices. However, it is to be appreciated that similar embodiments may also be implemented in other transistor architectures. For example, tri-gate transistor devices or planar transistor devices with Ge or SiGe channels may also benefit from low temperature nitridation.

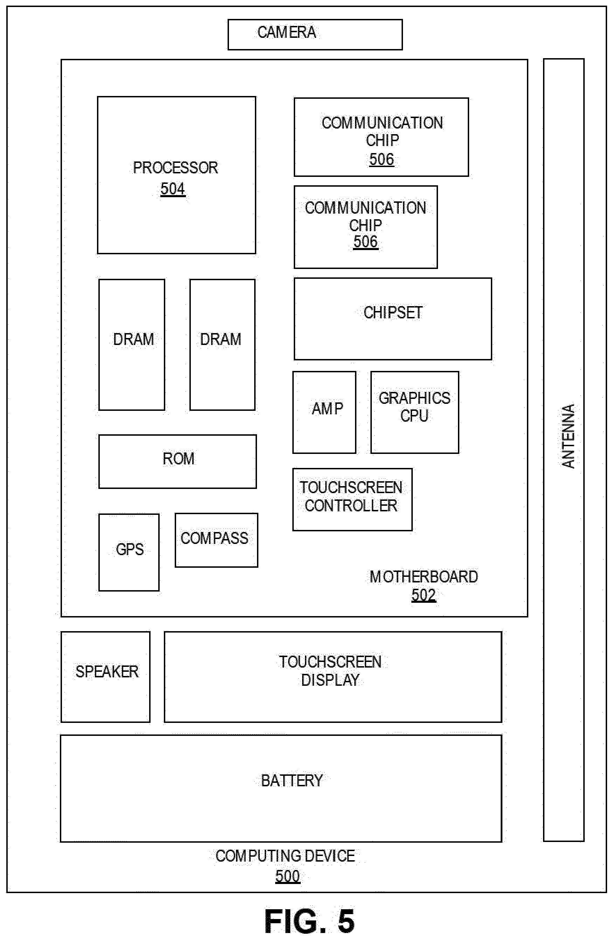

Figure 5 illustrates a computing device 500 in accordance with one implementation of an embodiment of the disclosure. The computing device 500 houses a board 502. The board 502 may include a number of components, including but not limited to a processor 504 and at least one communication chip 506. The processor 504 is physically and electrically coupled to the board 502. In some implementations the at least one communication chip 506 is also physically and electrically coupled to the board 502. In further implementations, the communication chip 506 is part of the processor 504.

Depending on its applications, computing device 500 may include other components that may or may not be physically and electrically coupled to the board 502. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 506 enables wireless communications for the transfer of data to and from the computing device 500. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 506 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 500 may include a plurality of communication chips 506. For instance, a first communication chip 506 may be dedicated to shorter range wireless communications such as Wi-Fi and Bluetooth and a second communication chip 506 may be dedicated to longer range wireless communications such as GPS, EDGE, GPRS, CDMA, WiMAX, LTE, Ev-DO, and others.

The processor 504 of the computing device 500 includes an integrated circuit die packaged within the processor 504. In an embodiment, the integrated circuit die of the processor may comprise a GAA transistor with a semiconductor channel that has a nitrided surface with a surface roughness that is less than approximately 1.0nm RMS, such as those described herein. The term "processor" may refer to any device or portion of a device that processes electronic data from registers and/or memory to transform that electronic data into other electronic data that may be stored in registers and/or memory.

The communication chip 506 also includes an integrated circuit die packaged within the communication chip 506. In an embodiment, the integrated circuit die of the communication chip may comprise a GAA transistor with a semiconductor channel that has a nitrided surface with a surface roughness that is less than approximately 1.0nm RMS, such as those described herein.

In further implementations, another component housed within the computing device 500 may comprise a GAA transistor with a semiconductor channel that has a nitrided surface with a surface roughness that is less than approximately 1.0nm RMS, such as those described herein.

In various implementations, the computing device 500 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 500 may be any other electronic device that processes data.

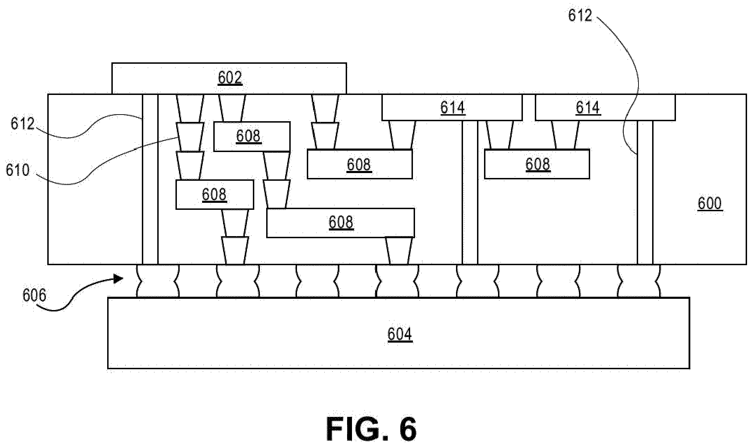

Figure 6 illustrates an interposer 600 that includes one or more embodiments of the disclosure. The interposer 600 is an intervening substrate used to bridge a first substrate 602 to a second substrate 604. The first substrate 602 may be, for instance, an integrated circuit die. The second substrate 604 may be, for instance, a memory module, a computer motherboard, or another integrated circuit die. In an embodiment, one of both of the first substrate 602 and the second substrate 604 may comprise a GAA transistor with a semiconductor channel that has a nitrided surface with a surface roughness that is less than approximately 1.0nm RMS, in accordance with embodiments described herein. Generally, the purpose of an interposer 600 is to spread a connection to a wider pitch or to reroute a connection to a different connection. For example, an interposer 600 may couple an integrated circuit die to a ball grid array (BGA) 606 that can subsequently be coupled to the second substrate 604. In some embodiments, the first and second substrates 602/604 are attached to opposing sides of the interposer 600. In other embodiments, the first and second substrates 602/604 are attached to the same side of the interposer 600. And in further embodiments, three or more substrates are interconnected by way of the interposer 600.

The interposer 600 may be formed of an epoxy resin, a fiberglass-reinforced epoxy resin, a ceramic material, or a polymer material such as polyimide. In further implementations, the interposer 600 may be formed of alternate rigid or flexible materials that may include the same materials described above for use in a semiconductor substrate, such as silicon, germanium, and other group III-V and group IV materials

The interposer 600 may include metal interconnects 608 and vias 610, including but not limited to through-silicon vias (TSVs) 612. The interposer 600 may further include embedded devices 614, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 600. In accordance with embodiments of the disclosure, apparatuses or processes disclosed herein may be used in the fabrication of interposer 600.

Thus, embodiments of the present disclosure may comprise a GAA transistor with a semiconductor channel that has a nitrided surface with a surface roughness that is less than approximately 1.0nm RMS, and the resulting structures.

The above description of illustrated implementations of the invention, including what is described in the Abstract, is not intended to be exhaustive or to limit the invention to the precise forms disclosed. While specific implementations of, and examples for, the invention are described herein for illustrative purposes, various equivalent modifications are possible within the scope of the invention, as those skilled in the relevant art will recognize.

These modifications may be made to the invention in light of the above detailed description. The terms used in the following claims should not be construed to limit the invention to the specific implementations disclosed in the specification and the claims. Rather, the scope of the invention is to be determined entirely by the following claims, which are to be construed in accordance with established doctrines of claim interpretation.
Example 1: a semiconductor device, comprising: a stack of semiconductor channels with a first end and second end, wherein individual ones of the semiconductor channels comprise a nitrided surface; a source region at the first end of the stack; a drain region at the second end of the stack; a gate dielectric surrounding the semiconductor channels; and a gate electrode surrounding the gate dielectric.
Example 2: the semiconductor device of Example 1, wherein a surface roughness of the nitrided surface is approximately 1nm root mean square (RMS) or less.
Example 3: the semiconductor device of Example 1 or Example 2, wherein individual ones of the semiconductor channels comprise germanium.
Example 4: the semiconductor device of Examples 1-3, wherein individual ones of the semiconductor channels comprise silicon and germanium.
Example 5: the semiconductor device of Examples 1-4, wherein the nitrided surface surrounds an entire perimeter of the individual ones of the semiconductor channels.
Example 6: the semiconductor device of Examples 1-5, wherein individual ones of the semiconductor channels are nanoribbon channels.
Example 7: the semiconductor device of Examples 1-5, wherein individual ones of the semiconductor channels are nanowire channels.
Example 8: the semiconductor device of Examples 1-6, wherein the nitrided surface is nitrided with a nitrogen plasma.
Example 9: the semiconductor device of Example 8, wherein a temperature during the nitrogen plasma is approximately 350°C or less.
Example 10: a semiconductor device, comprising: a semiconductor channel, wherein the semiconductor channel is a nanowire channel or a nanoribbon channel; and a nitrided surface surrounding an entire perimeter of the semiconductor channel, wherein a surface roughness of the semiconductor channel is approximately 1nm rout mean square (RMS) or less.
Example 11: the semiconductor device of Example 10, wherein the semiconductor channel comprises germanium.
Example 12: the semiconductor device of Example 10, wherein the semiconductor channel comprises silicon and germanium.
Example 13: the semiconductor device of Examples 10-12, wherein the nitrided surface is nitrided with a nitrogen plasma.
Example 14: the semiconductor device of Example 13, wherein a temperature during the nitrogen plasma is approximately 350°C or less.
Example 15: the semiconductor device of Examples 10-14, further comprising: a gate dielectric surrounding the entire perimeter of the semiconductor channel; and a gate electrode surrounding the gate dielectric.
Example 16: a method of forming a semiconductor device, comprising: forming a semiconductor channel, wherein the semiconductor channel is a nanowire channel or a nanoribbon channel; nitriding a surface of the semiconductor channel, wherein a nitriding process comprises forming a plasma from N₂ gas at a temperature below approximately 350°C, wherein the nitrided surface surrounds an entire perimeter of the semiconductor channel; disposing a gate dielectric around the semiconductor channel; and disposing a gate electrode around the gate dielectric.
Example 17: the method of Example 16, wherein the nitrided surface has a surface roughness that is approximately 1nm root mean square (RMS) or less.
Example 18: the method of Example 16 or Example 17, wherein the semiconductor channel comprises germanium or germanium and silicon.
Example 19: an electronic system, comprising: a board; an electronic package coupled to the board; and a die electrically coupled to the electronic package, wherein the die comprises: a semiconductor channel, wherein the semiconductor channel is a nanowire channel or a nanoribbon channel; and a nitrided surface surrounding an entire perimeter of the semiconductor channels, wherein a surface roughness of the semiconductor channel is approximately 1nm rout mean square (RMS) or less.
Example 20: the electronic system of Example 19, wherein the semiconductor channel comprises germanium or germanium and silicon.

## Claims

1. A semiconductor device, comprising:
a stack of semiconductor channels with a first end and second end, wherein individual ones of the semiconductor channels comprise a nitrided surface;
a source region at the first end of the stack;
a drain region at the second end of the stack;
a gate dielectric surrounding the semiconductor channels; and
a gate electrode surrounding the gate dielectric.

2. The semiconductor device of claim 1, wherein a surface roughness of the nitrided surface is approximately 1nm root mean square (RMS) or less.

3. The semiconductor device of claim 1 or 2, wherein individual ones of the semiconductor channels comprise germanium.

4. The semiconductor device of claim 1, 2 or 3, wherein individual ones of the semiconductor channels comprise silicon and germanium.

5. The semiconductor device of claim 1, 2, 3 or 4, wherein the nitrided surface surrounds an entire perimeter of the individual ones of the semiconductor channels.

6. The semiconductor device of claim 1, 2, 3, 4 or 5, wherein individual ones of the semiconductor channels are nanoribbon channels.

7. The semiconductor device of claim 1, 2, 3, 4 or 5, wherein individual ones of the semiconductor channels are nanowire channels.

8. The semiconductor device of claim 1, 2, 3, 4, 5 or 6, wherein the nitrided surface is nitrided with a nitrogen plasma.

9. The semiconductor device of claim 8, wherein a temperature during the nitrogen plasma is approximately 350°C or less.

10. A method of forming a semiconductor device, comprising:
forming a semiconductor channel, wherein the semiconductor channel is a nanowire channel or a nanoribbon channel;
nitriding a surface of the semiconductor channel, wherein a nitriding process comprises forming a plasma from N₂ gas at a temperature below approximately 350°C, wherein the nitrided surface surrounds an entire perimeter of the semiconductor channel;
disposing a gate dielectric around the semiconductor channel; and
disposing a gate electrode around the gate dielectric.

11. The method of claim 10, wherein the nitrided surface has a surface roughness that is approximately 1nm root mean square (RMS) or less.

12. The method of claim 10 or 11, wherein the semiconductor channel comprises germanium or germanium and silicon.
